# EUROPEAN PATENT APPLICATION

(11) **EP 1 248 371 A1**
(43) Date of publication of application: **09.10.2002**
(21) Application number: 01830242.2
(22) Date of filing: 06.04.2001
(51) Int. Cl.: H03K 19/0185, H03F 3/45

(54) **A converter for converting the level of differential signals**

(71) Applicant: STMicroelectronics S.r.l., 20041 Agrate Brianza (Milano) (IT)
(72) Inventor: Clerici, Gian Carlo, 20090 Vimodrone (Milano) (IT); Tomasini, Luciano, 20051 Monza (Milano) (IT)
(74) Representative: Maggioni, Claudio

(57) **Abstract**

The converter comprises a differential amplifier (DIF) having two differential input signals of a first level (Vᵢₙ₊, Vᵢₙ₋) and two differential outputs (Vₒᵤₜ₊, Vₒᵤₜ₋), and two output buffers each comprising an inverter (I1, I2) with an input connected to an output of the differential amplifier. In order to produce a symmetrical circuit with output signals having leading and trailing edges and duty-cycles identical to those of the input signals, the converter comprises means (Rv) with adjustable conductivity through which the current (Io) of the differential amplifier passes, and a feedback circuit comprising a generator (Iref) which generates a reference potential (Vref) and is formed by circuit components of shapes and dimensions correlated in predetermined manner with the shapes and dimensions of the components of the inverter (I1, I2). The feedback circuit is connected between a node (N) of the differential amplifier (DIF) which, in operation, is at an intermediate potential between the potentials of the differential outputs, and a regulation terminal of the means (Rv) with adjustable conductivity, in order to regulate the supply voltage of the differential amplifier in a manner such as to keep the potential of the node (N) which is at the intermediate potential at the reference potential which is also the "trigger" potential of the inverters.

## Description

The present invention relates to a converter for converting differential signals of a first level into differential signals of a second level, as defined in the preamble of Claim 1.

It is known that, in data-processing and transmission systems in integrated circuits, use is made of logic circuits such as those known as ECL (emitter-coupled logic) or LVDS circuits which process fairly low-level differential signals in order to achieve a high data-transmission speed with low emission of electromagnetic interference (EMI), low injection of interference into the substrate, and low energy consumption. It is also known that, in many applications, the low-level differential signals have to be converted into higher-level signals for use in logic circuits of different types, for example, CMOS circuits.

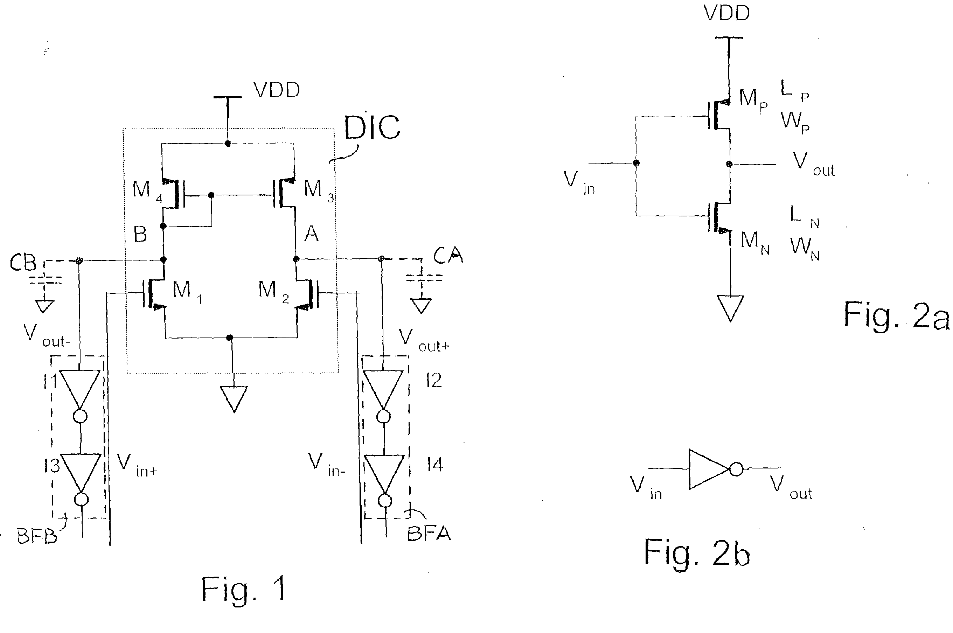

A typical known converter which can convert from ECL logic to CMOS logic is shown in Figure 1. It comprises a differential circuit DIC and two output buffers BFB, BFA each constituted by a pair of signal-transducer stages, for example, inverters, I1, I3 and I2, I4. The differential circuit DIC is formed by two n-channel MOS transistors M₁, M₂ with their source terminals connected together to the negative terminal, indicated by the earth symbol, of a voltage supply, and with their drain terminals connected to the two branches of a current mirror formed by two p-channel MOS transistors M₄ and M₃. More particularly, the transistors M₄ and M₃ have their source terminals connected together to the positive terminal VDD of the voltage supply and their gate terminals connected together to the drain terminal of the transistor M₄, and each has its drain terminal connected to the drain terminal of a respective transistor M₁ or M₂. The gate terminals of the transistors M₁ and M₂ constitute the differential inputs of the circuit and are connected to an ECL logic circuit (not shown); the drain terminals of the same transistors, which are indicated as circuit nodes B and A, constitute the differential outputs of the circuit and each is connected to the input of a respective inverter I1 or I2. The inverters I1 and I2 in turn have their outputs connected to the inputs of the inverters I3 and I4, respectively. The outputs of these further inverters constitute the differential outputs of the converter to be connected to a CMOS logic circuit (not shown).

In operation, the ECL differential input signal, which is constituted by a voltage variable between two levels, for example Vin=+0.7V and Vin=-0.7V, which are centred with respect to a reference terminal at 0 potential, is amplified by the differential circuit. The differential output signal Vₒᵤₜ₋, Vₒᵤₜ₊ varies with respect to a common-mode voltage V_{cm}=(Vₒᵤₜ₊-Vₒᵤₜ₋)/2. The leading and trailing edges of this signal depend on the parasitic capacitances associated with the output nodes A and B of the differential circuit, which are represented by capacitors shown by broken lines and indicated CA and CB in Figure 1. In order to have the lowest possible capacitances and hence the fastest possible switching speeds, CMOS inverter circuits are often used as interface or buffer circuits between the output of the differential circuit and the CMOS logic circuit. The inverter is in fact the simplest and smallest operative unit, and hence the unit with the smallest input capacitance, which can drive a signal variable between two levels. In order to produce a signal of maximum amplitude, that is, a signal which is variable substantially between 0 and VDD (for example, 0-5V), to be applied as an input to a CMOS logic circuit, more than one inverter may be required if the signal to be converted is of high frequency. In the example of Figure 1, a buffer constituted by two inverters in cascade is used for each output of the differential circuit but, in other applications a single stage, that is, a single inverter, may suffice, or in yet further applications, more than two may be required.

The converter of Figure 1 has some disadvantages. In fact, the upward slope of the signals Vₒᵤₜ₊, Vₒᵤₜ₋ which are present at the nodes A and B generally differs from the downward slope so that the ratios between the period and the duration (the duty-cycle) of the pulses output by I1 and I2 are generally different. Moreover, the common-mode output voltage of the differential circuit (V_{cm}=(Vₒᵤₜ₊-Vₒᵤₜ₋)/2) is not necessarily centred with respect to the dynamic ranges of the inverters, so that the output signals of the inverters are not complementary and this may cause distortions in the duty-cycle or even missed switchings. This occurs basically because the V_{cm} depends on the variability of the parameters of the process for the manufacture of the integrated circuit, on the energy supply, and on temperature. This problem is aggravated by the fact that the characteristics of the inverters may differ unpredictably from the design characteristics because of the variability of the parameters of the manufacturing process, and also depend on the energy supply and on the operating temperature of the circuit, as well as on its dimensions. These disadvantages of the prior art will be described in greater detail below.

The object of the present invention is to propose a converter circuit of the type described above which does not have the disadvantages of the known circuit, that is, which is completely symmetrical in operation and has output signals in which the slopes of the leading and trailing edges and the duty-cycles are identical to the slopes of the leading and trailing edges and to the duty-cycles of the input signals, respectively, this being achieved without foregoing low consumption and the occupation of an extremely small area.

This object is achieved by the provision of the circuit defined and characterized in general in Claim 1.

The invention will be understood further from the following detailed description of an embodiment thereof, given by way of non-limiting example, with reference to the appended drawings, in which:
Figure 1 is a diagram, partially in circuit form and partially in block form, of a known converter,
Figures 2a and 2b show the circuit diagram and the graphic symbol of an inverter, respectively,
Figures 3a, 3b and 3c show three characteristic curves of an inverter, drawn by making different approximations,
Figure 4 shows the characteristic curves of three inverters formed with different dimensions,
Figure 5 shows some input and output wave-forms of an inverter, showing the effect on the duty-cycle of a deviation from the design characteristic,
Figure 6 shows an embodiment of the converter according to the invention, and
Figure 7 shows the full circuit diagram of the converter of Figure 6.

For a better understanding of the disadvantages of the prior art and hence a better appreciation of the advantages of the invention, Figures 2 to 5 and the following remarks will be considered.

An analysis of the operation of the known circuit of Figure 1 shows that this circuit has asymmetric behaviour. For example, a situation in which the transistor M₁ is not conductive and the transistor M₂ is conductive is considered and it is assumed that there is a transition of the input potential Vᵢₙ₊ from the low level to the high level and, correspondingly, a transition of opposite sign of the potential Vᵢₙ₋. The transistor M₁ starts to conduct a current which tends to discharge the input capacitor CB of the inverter I1. The potential Vₒᵤₜ₋ drops because the capacitor CB is discharged. When the discharge is completed, current starts to flow in the transistor M₄, which is connected as a diode. This current is reflected in the transistor M₃; since the transistor M₂ is becoming non-conductive because Vᵢₙ₋ is changing from the high level to the low level, this current charges the input capacitor CA of the inverter I2. The potential of the node A rises and the output voltage Vₒᵤₜ₊ increases until the transistor M₃ stops conducting, whilst the transistors M₄ and M₁ continue to conduct. In short, the switching of the input signal causes an exchange of charges between the input capacitors of the inverters I1 and I2. However, this exchange takes place neither directly nor simultaneously. In fact, the capacitor CA is charged through the current mirror and is discharged directly through the transistor M₂, whereas the capacitor CB is charged and discharged directly, through the diode M₄ and through the transistor M₁, respectively. The switching times are therefore different, that is, the slopes of the leading and trailing edges of the wave-forms of the output signal of the differential circuit are different. As already stated, for this reason, the duty-cycle of the signals output by the inverters I1 and I2 will generally be different.

A generic inverter such as that shown in Figure 2a will now be considered. The inverter is constituted by two complementary MOS transistors M_{P} and M_{N}, that is a p-channel transistor and an n-channel transistor, respectively, which have channel lengths and widths L_{N} and L_{P}, W_{N} and W_{P}, respectively, and are connected between the negative terminal (earth) and the positive terminal (VDD) of a voltage supply. A voltage Vᵢₙ is applied to the input terminal which is connected to the gate electrodes of the two transistors, and an output voltage Vₒᵤₜ is taken from the output terminal which is constituted by the connection node between the drain terminals of the two transistors. Figure 2b shows the graphic symbol for an inverter.

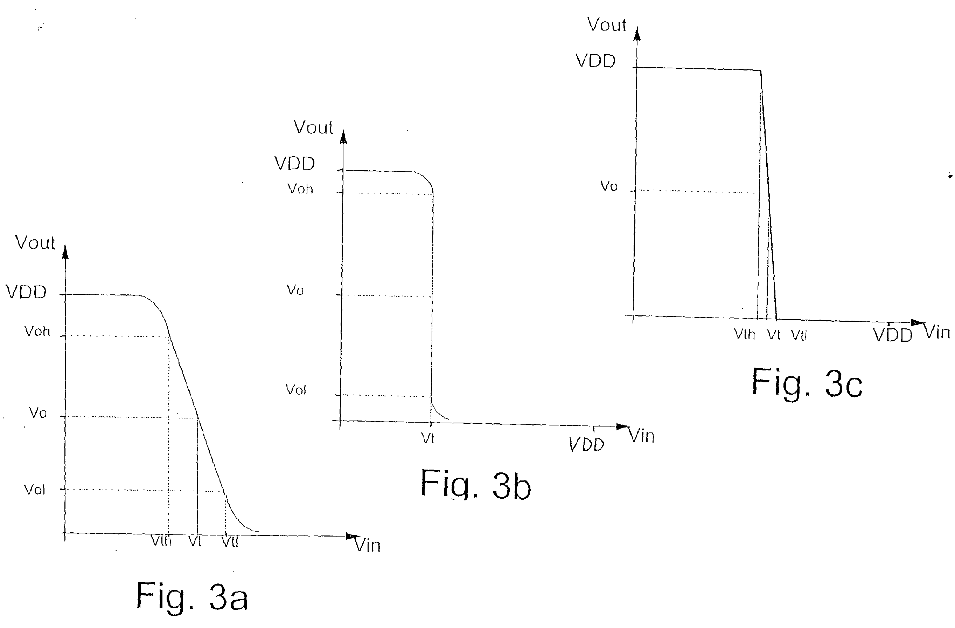

Figure 3a shows the basic characteristic Vᵢₙ/Vₒᵤₜ of the inverter, in which Vth and Vtl indicate the values which delimit the input range, Voh and Vol indicate the values which delimit the output range, and Vt and Vo indicate the "trigger" voltage of the inverter and the corresponding output voltage, respectively. The trigger voltage Vt is the voltage which, when applied as an input, gives rise to an output voltage equal to the input voltage. The slope of the linear portion of the characteristic curve represents the gain of the inverter and depends, as does the trigger voltage Vt, on the geometric parameters L_{P}, L_{N}, W_{P}, and W_{N} of the two transistors.

Figure 3b represents a first-order approximation of the characteristic of an inverter, which is useful when the gain of the inverter can be approximated to an infinite value and Figure 3c represents another approximation which is useful when the gain cannot be considered infinite and when the transitions from the linear zone to the saturation zone can be considered instantaneous.

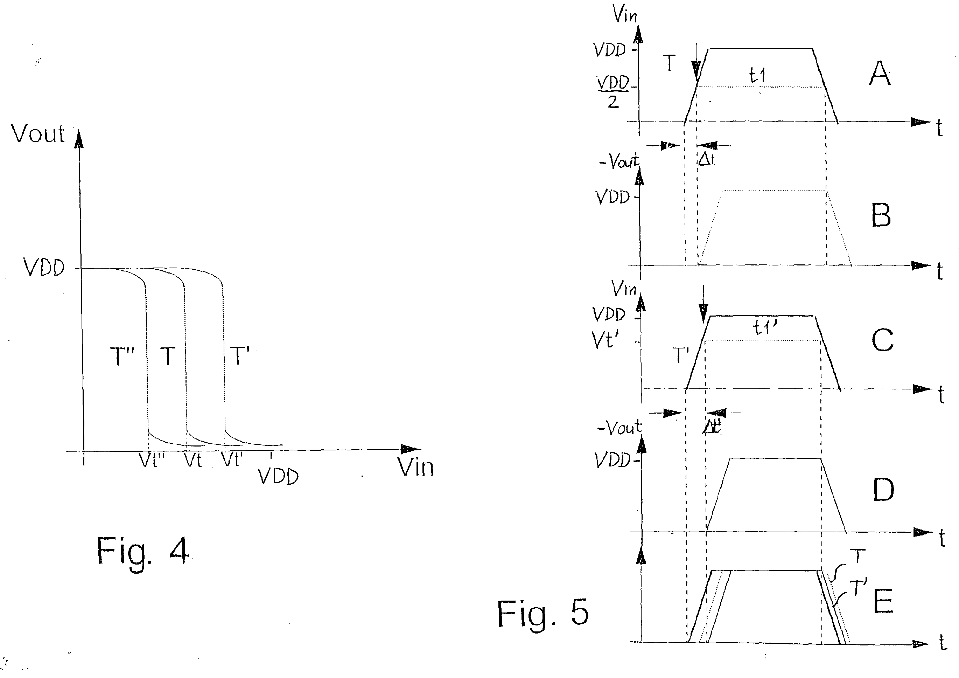

Figure 4 shows the idealized characteristics, all of which are similar to that of Figure 3b and are indicated T, T', and T'', and which are obtained by varying the geometrical parameters of the transistors of the inverter so as to achieve different trigger voltages Vt, Vt', Vt''. The effect of the variation of the characteristic from T to T' on the behaviour of the inverter is shown in Figure 5. Similar considerations apply to T''.

In Figure 5, the wave-form A shows a pulse Vᵢₙ (for example, between 0 and VDD) of duration t1, applied as an input to an inverter having the trigger voltage Vt, which is centred relative to earth and VDD. The wave-form B shows the pulse Vₒᵤₜ output by the inverter, upon the assumption that its characteristic curve is that of Figure 3c, but in which it is assumed that Vt=Vtl=Vh, and that the slopes of the leading and trailing edges are identical to those of the input wave-form. In these ideal conditions, the output pulse differs from the input pulse purely by a delay Δt.

The wave-form C of Figure 5 shows a pulse Vᵢₙ of duration t1', applied as an input to an inverter having a trigger voltage Vt' > VDD/2, for example, such as that having the characteristic curve T' in Figure 4. The output pulse Vₒᵤₜ is shown as the wave-form D in Figure 5; as can be seen, it has a leading edge which is delayed by a time Δt'>Δt relative to the input pulse and a trailing edge which is advanced relative to that of the output pulse of the inverter with the characteristic T so that the duty-cycle is modified and is different from (shorter than) the input duty-cycle. The input pulse and the output pulses in the two cases are shown together at point E of Figure 5.

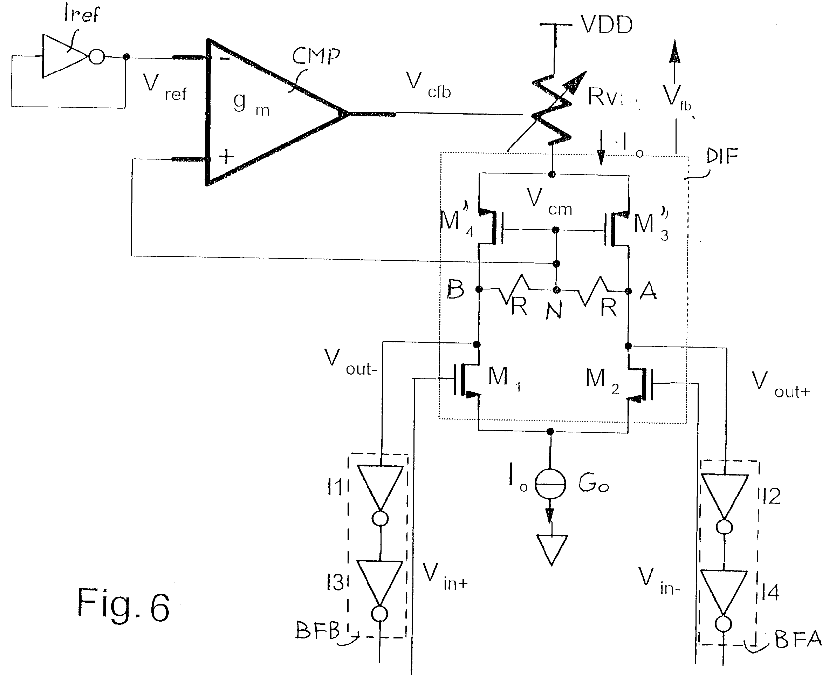

The circuit according to the invention will now be considered with reference to Figure 6, in which components identical or corresponding to those of the known circuit of Figure 1 are indicated by the same reference symbols. The differential circuit, indicated DIF in this case, differs from that of Figure 1 in that, instead of the p-channel transistors M₃ and M₄ connected as a current mirror, there are two p-channel transistors M₃' and M₄' having their gate electrodes connected together to the connection node N between two identical resistors R connected in series between the nodes A and B. The interconnected source electrodes of the transistors M₃' and M₄' constitute a supply terminal of the differential circuit DIF and are connected to the positive terminal of the voltage supply VDD by means of a component Rv equivalent to a variable resistor. The source electrodes of the transistors M₁ and M₂ are connected to the negative terminal of the voltage supply, indicated by the earth symbol, via a constant-current generator Go.

A feedback circuit, comprising a generator Iref for generating a reference potential and a comparator CMP, is connected between the node N and the regulation terminal of the resistor Rv. More particularly, the node N is connected to an input terminal of the comparator CMP. The inverter Iref is structurally identical to the inverters I1 and I2, that is, it is formed by circuit components the shapes and dimensions of which are correlated in a predetermined manner with the shapes and dimensions of the circuit components of the inverters I1 and I2. It has its input and its output joined together at a common terminal connected to the second input of the comparator CMP. The output of the comparator CMP is connected to the regulation terminal of the variable resistor Rv.

The inverter Iref generates a reference voltage V_{ref} which is equal to its own trigger voltage Vt and to the trigger voltage of the inverters I1 and I2. The voltage Vt may be selected so as to be equal to VDD/2, but may also differ from this value; in any case, V_{ref}=Vt, because of the feedback. The voltage present at the node N is the common-mode voltage V_{cm} of the differential circuit. The comparator CMP compares the common-mode voltage V_{cm} with the reference voltage V_{ref}=Vt and generates a positive or negative output signal V_{cfb} in dependence on the outcome of the comparison. The signal V_{cfb} regulates the resistance of the resistor Rv and hence the supply voltage of the differential circuit in a direction such as to keep the voltage V_{cm} fixed at the voltage Vt. More particularly, the error voltage V_{cfb} modulates the variable resistance Rv, and hence the feedback voltage Vfb=Rv*Io, where Io is the constant current generated by the generator Go. The two transistors M₃' and M₄' in this embodiment are identical and the same common-mode current Io/2 flows through them so that their gate-source voltages Vgs are constant and equal. The voltage which is to be controlled, that is V_{cm}, where Vcm=VDD-Vgs-Rv*Io=K-Rv*Io, where K is a constant, is controlled by modifying the resistance of the resistor Rv.

With the circuit according to the invention, the output of the differential circuit is always centred with respect to the common-mode voltage V_{cm} which is equal to Vt, and is perfectly symmetrical so that the slopes of the leading and trailing edges of the output signal are always identical. Moreover, the circuit adapts automatically to variations in the characteristics of the inverters due to the variability of the manufacturing process, to the energy supply, and to temperature variations, so that the output signals of the differential circuit are always centred with respect to the dynamic ranges of the inverters.

It will also be noted that the optimal centring of V_{cm} is achieved by a feedback circuit which has direct-current input and output signals (V_{cm}, V_{ref} and V_{cfb}). In particular, the fairly narrow pass-band of the feedback circuit is advantageous because it ensures good filtering of any high-frequency interference or undesired couplings between inputs and outputs. The feedback circuit is very simple because it can be formed by a single operational amplifier as the comparator with a transistor as feedback actuator and with two resistors between the nodes A and B. It will be noted that, as well as having the functions of common-mode voltage sensors, the two resistors R have the function of load resistors for the transistors M₁ and M₂ of the differential circuit. The signal path is completely separate from the V_{cm} control path and comprises a very small number of elements. In fact, between the input and output nodes, there is only one gate-drain junction and one resistor R, so that the leading and trailing edges are very steep.

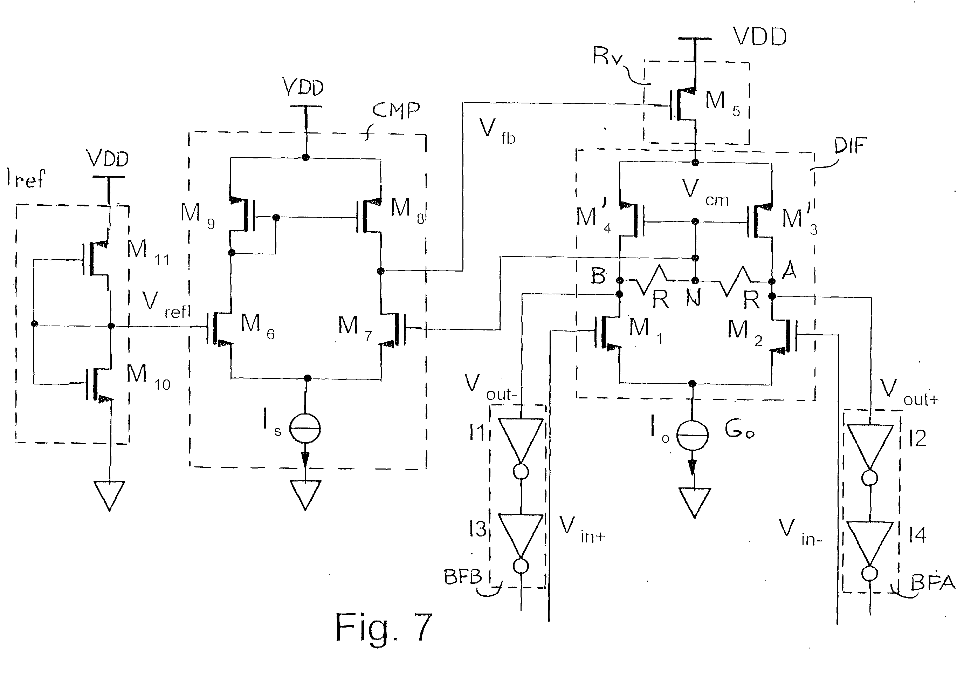

A practical embodiment of the circuit of Figure 6 is shown in Figure 7, in which components identical to those of Figure 6 are indicated by the same reference symbols. The comparator is constituted by a simple differential circuit formed by two n-channel MOS transistors M₆ and M₇ which have common source electrodes connected to earth via a constant-current generator Gs, which have their gate electrodes as inputs, and each of which has its drain electrode connected to a branch of a current mirror formed by two p-channel MOS transistors M₈ and M₉ having their source electrodes connected to the positive terminal of the supply (VDD). The inverter Iref is formed by two complementary MOS transistors M₁₀ and M₁₁ connected between VDD and earth and having their gate electrodes connected together to the output, that is, to the node to which their drain electrodes are connected. Instead of the variable resistor Rv, a p-channel MOS transistor M₅ is provided as the element with adjustable conductivity and has gate electrode connected, as the regulation terminal, to the output of the comparator CMP, that is, to the common drain electrodes of the transistors M₇ and M₈.

According to a variant which further simplifies the circuit structure of the converter, the generator Go may be omitted and the source electrodes of the transistors M₁ and M₂ may be connected directly to earth.

In summary, the converter circuit according to the invention has all of the following advantageous characteristics: differential input and output, complete symmetry, static feedback, high speed in the signal path, automatic adaptation to process, supply and temperature variations, low consumption, a small number of components, and simplicity of construction.

## Claims

1. A converter for converting input differential signals of a first level into output differential signals of a second level, formed in an integrated circuit, and comprising:
a differential amplifier (DIF) having two supply terminals, two differential inputs for receiving signals of the first level (Vᵢₙ₊, Vᵢₙ₋) and two differential outputs (Vₒᵤₜ₊, Vₒᵤₜ₋),
two output buffers each comprising a signal-transducer stage (I1, I2) formed by components of predetermined shape and dimensions and each having an input connected to an output of the differential amplifier,
**characterized in that** it comprises:
means (Rv) with adjustable conductivity, connected in a manner such that the current (Io) absorbed by the differential amplifier passes through the means (Rv),
a feedback circuit comprising a generator (Iref) for generating a reference potential (V_{ref}), the generator (Iref) being formed by circuit components of shapes and dimensions which are correlated in predetermined manner with the shapes and dimensions of the circuit components of the signal-transducer stage (I1, I2),
the feedback circuit being connected between a node (N) of the differential amplifier (DIF) which, in operation, is at an intermediate potential between the potentials of the differential outputs, and a regulation terminal of the means (Rv) with adjustable conductivity, and being able to regulate the supply voltage of the differential amplifier in a manner such as to keep the potential of the node (N) which is at the intermediate potential at the reference potential (Vref).

2. A converter according to Claim 1 in which the feedback circuit comprises a comparator (CMP) having a first input connected to the node (N) of the differential amplifier which is at the intermediate potential, a second input connected to the reference-potential generator (Iref), and an output connected to the regulation terminal of the means (Rv) with adjustable conductivity.

3. A converter according to Claim 1 or Claim 2 in which the signal-transducer stage is an inverter (I1, I2) and the components of predetermined shapes and dimensions comprise an n-channel MOS transistor and a p-channel MOS transistor, and in which the reference-potential generator (Iref) is formed by an inverter which comprises an n-channel MOS transistor and a p-channel MOS transistor of shapes and dimensions identical or proportional to those of the n-channel and p-channel MOS transistors of the transducer stage (I1, I2) and which has its input and output short-circuited.

4. A converter according to any one of Claims 1, 2 or 3, in which the means (Rv) with adjustable conductivity comprise a MOS transistor (M₅) connected with its drain-source path between one of the supply terminals of the differential amplifier and a terminal of a supply (VDD).

5. A converter according to any one of the preceding claims in which the differential amplifier comprises two MOS transistors of a first type (M₁, M₂) with their source electrodes connected together to a first terminal of a supply and with their drain electrodes connected to respective drain electrodes of two MOS transistors (M₄', M₃') of a type complementary to the first type, each of the connection nodes between the drain electrodes being connected to one of the two differential outputs, the two complementary transistors (M₄', M₃') having their gate electrodes connected together to the node (N) which is at an intermediate potential, between two identical resistors connected in series with one another between the differential outputs, and their source electrodes connected together to a second supply terminal (VDD), via the means (Rv) with adjustable conductivity.

6. A converter according to Claim 5 in which the source electrodes of the two MOS transistors of the first type (M₁, M₂) are connected to the first supply terminal via a constant-current generator (Go).

7. A converter according to any one of the preceding claims in which the comparator (CMP) comprises an operational amplifier.
